# EUROPEAN PATENT APPLICATION

(11) **EP 0 989 592 A1**
(43) Date of publication of application: **29.03.2000**
(21) Application number: 99117798.1
(22) Date of filing: 09.09.1999
(51) Int. Cl.: H01L 21/00

(54) **Tape stripping apparatus and tape stripping method**

(30) Priority: 10.09.1998 JP 25709898; 16.10.1998 JP 29540298
(71) Applicant: Disco Corporation, Ohta-ku, Tokyo 144-0033 (JP)
(72) Inventor: Koma, Yutaka, c/o Disco Corporation, Tokyo (JP)
(74) Representative: Hoarton, Lloyd Douglas Charles

(57) **Abstract**

There are provided a tape stripping apparatus which is simple in mechanism and can be incorporated into a grinding apparatus or the like and a tape stripping method. The tape stripping apparatus strips a protective tape, for protecting a plate-like object, which has become unnecessary after a specified operation is completed and is a thermoshrinkable tape. The tape stripping apparatus includes: holding unit for holding the plate-like object; and warm medium supply unit for supplying a warm medium to the thermoshrinkable tape adhered to the surface of the plate-like object, the other surface of which is held by the holding unit. The warm medium supply unit may also be submersible. The thermoshrinkable protective tape can be stripped by submersing the plate-like object in warm water reserved in a tub or warm water tank or by spraying warm water from a warm water supply pipe.

## Description

### BACKGROUND OF THE INVENTION

### 1. Field of the Invention

The present invention relates to a tape stripping apparatus and a tape stripping method.

### 2. Background Art

In a conventional process of grinding a plate-like object such as a semiconductor water, a protective tape is adhered to the pattern side of the plate-like object formed with ICs prior to the grinding process such that the pattern side is protected from damage and contamination. After the grinding process, the plate-like object is carried out of a grinding apparatus and transported to a tape stripping apparatus where the protective tape is stripped from the plate-like object.

However, the foregoing conventional technique requires the installation of a special-purpose tape stripper for stripping a tape and the installation of a special-purpose washer for washing the pattern side after the tape is stripped. Since the tape stripper and the washer are installed separately, a considerable investment in plant and equipment, and installation space are required disadvantageously.

### SUMMARY OF THE INVENTION

The present invention has been achieved in order to eliminate the conventional disadvantage and it is therefore an object of the present invention to provide a tape stripping apparatus which is simple in mechanism and can be incorporated into a grinding apparatus or the like and a tape stripping method.

As technical means for attaining the object, the present invention provides a tape stripping apparatus for stripping a protective tape, for protecting a plate-like object, the tape being a thermoshrinkable tape, the apparatus comprising: holding means for holding the plate-like object; and warm medium supply means for supplying a warm medium to the tape adhered to a surface of the plate-like object, the other surface of the plate-like object being held by the holding means.

Preferably, the tape stripping apparatus further comprises discarding means for discarding the protective tape being shrinked and twisted on the plate-like object by the warm medium supplied from the warm medium supply means.

As described above, the tape stripping apparatus according to the present invention comprises the holding means for holding the plate-like object; and the warm medium supply means for supplying the warm medium to the tape adhered to the surface of the plate-like object held by the holding means, so that it is simple in mechanism and manufacturable at low cost.

Since the tape stripping apparatus is simple in mechanism, it can be incorporated into a machining apparatus such as a grinding apparatus so that the thermoshrinkable protective tape that has become unnecessary after a certain operation is completed is strippable in the machining apparatus. This obviates the necessity to provide an independent tape stripping process and improves productivity.

The present invention also provides a tape stripping method for stripping, from a plate-like object, a protective tape adhered to the plate-like object, the tape being a thermoshrinkable tape, the method being implemented by using a grinding apparatus including the tape stripping apparatus as above, the grinding apparatus comprising: a chuck table for holding the plate-like object under suction; grinding means for grinding the plate-like object held on the chuck table; transporting means for removing, from the chuck table, the plate-like object ground by the grinding means and transporting the plate-like object; and washing means, for holding and washing the plate-like object transported by the transporting means, comprising a spinner table, the method comprising: a holding step of placing the plate-like object on the chuck table with the tape adhered to the plate-like object facing the chuck table and holding the plate-like object under suction; a grinding step of grinding the plate-like object held on the chuck table by using the grinding means; a transporting step of removing, after the grinding step is completed, the plate-like object from the chuck table and transporting the plate-like object to the spinner table of the washing means; a washing step of holding the plate-like object under suction with the tape adhered to the plate-like object facing the spinner table and washing the plate-like object with the ground surface thereof facing outward, while supplying washing water to the plate-like object; a plate-like object inverting step of inverting the plate-like object after the washing step is completed and placing again the plate-like object on the spinner table with the tape facing outward; warm medium supplying step of supplying warm medium at a desired temperature from warm medium supply means of the tape stripping apparatus to the tape; and a discarding step of discarding the tape being shrinked and twisted on the plate-like object by using discarding means.

In accordance with the present invention, the tape stripping apparatus for stripping the protective tape adhered to the plate-like object such as a semiconductor wafer is incorporated in the washing means of the grinding apparatus such that the tape is strippable and the plate-like object is washable after the stripping process. This obviates the necessity to separately install a special-purpose tape stripper and a special-purpose washer as has been installed conventionally and reduces an investment in plant and equipment as well as an installation space, thereby achieving the excellent effects of increased economy and efficiency.

In the tape stripping apparatus and/or the tape stripping method, the warm medium may be one selected from the group consisting of warm water and warm air.

Furthermore, in the tape stripping apparatus and/or the tape stripping method according to the present invention, the plate-like object may be a semiconductor wafer.

These and other objects and advantages of the present invention will become clear from the following description with reference to the accompanying drawings.

### BRIEF DESCRIPTION OF THE DRAWINGS

Fig. 1 is a perspective view of a grinding apparatus into which a tape stripping apparatus in an embodiment of the present invention is incorporated;
Fig. 2 is a perspective view of the outward appearance of a plate-like object;
Fig. 3 is a schematic perspective view showing a tape stripping apparatus in another embodiment of the present invention;
Figs. 4(A) and 4(B) illustrate an embodiment using a submersible warm medium supply means;
Figs. 5(A) and 5(B) illustrate an embodiment using a warm water tank; and
Figs. 6(A) and 6(B) illustrate an embodiment in which warm water is sprayed from a warm water supply pipe.

### DETAILED DESCRIPTION OF THE PREFERRED EMBODIMENTS

Referring now to the drawings, the embodiments of the present invention will be described with reference to the accompanying drawings.

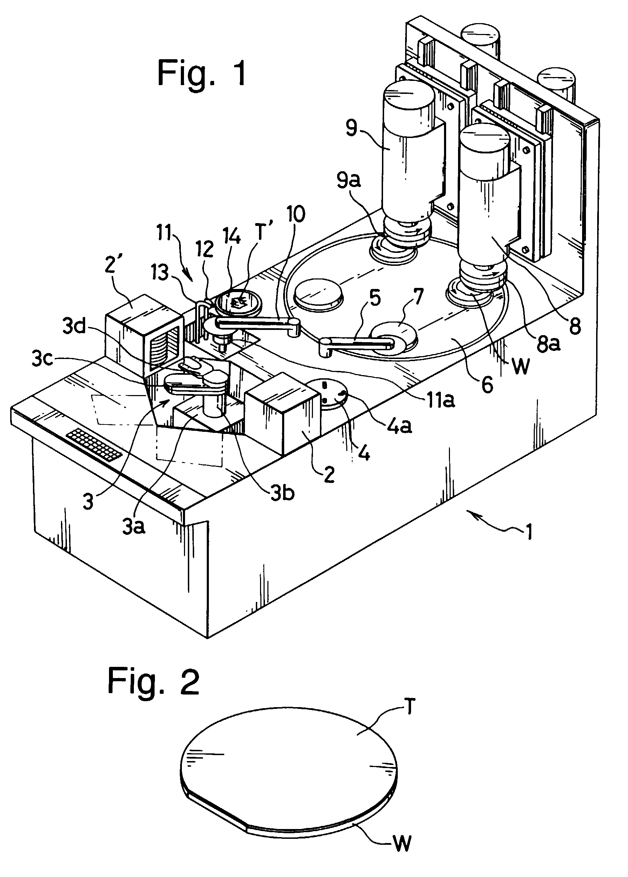

Fig. 1 shows a grinding apparatus into which a tape stripping apparatus in an embodiment of the present invention is incorporated. In the grinding apparatus 1, a plate-like object as a target material to be ground is contained in a cassette 2. In this case, the plate-like object W is a semiconductor wafer having a protective tape T adhered to the side thereof formed with an IC pattern, as shown in Fig. 2. In the present invention, the protective tape T is a thermoshrinkable tape (hereinafter called as the thermoshrinkable tape T) and may be a typical one composed of, e.g., a stretched ethylene-vinyl acetate copolymer (with a thickness of about 100 µm) formed with an acrylic adhesive layer (with a thickness of 10 to 50 µm).

The plate-like object W is contained in the cassette 2 with the thermoshrinkable tape T facing downward. The plate-like object W is initially carried out of the cassette 2 and transported to a standby region 4 by a transporting/inverting unit 3 as transporting/inverting means.

The transporting/inverting unit 3 includes a base 3a which is vertically movable, a rotation shaft 3b attached to the base 3a, a plurality of pivoting arms 3c coupled extendably to the rotating shaft 3b, and a two-pronged sucking member 3d attached to the tip of the pivoting arms 3c. The sucking member 3d is formed 180° inversible at the root portion thereof.

The plate-like object W transported to the standby region 4 has a center position aligned by a plurality of aligning pieces 4a moving toward the center, sucked by a first transporting unit 5 as transporting means which is pivotable and vertically movable, and transported thereby to a chuck table 7 disposed on a turn table 6 so that it is held under suction on the top surface of the chuck table 7.

The plate-like object W held under suction on the chuck table 7 is positioned under a first grinding unit 8 as grinding means with the rotation of the turn table 6 and subjected to a rough grinding process using a rotary grinding wheel attached to the lower end of the first grinding unit 8. In the mean time, the chuck table 7 also rotates and grinding water is supplied to the surface being ground.

After the rough grinding process is completed, the plate-like object W is positioned under a second grinding unit 9 as grinding means with the rotation of the turn table 6 and subjected to a finishing grinding process using a rotary grinding wheel 9a attached to the lower end of the second grinding unit 9. During the process, the chuck table 7 also rotates and grinding water is supplied to the surface being ground.

After the finishing grinding process is completed, the plate-like object W is indexed to a retrieval position, sucked by a second transporting unit 10 as transporting means, removed from the chuck table 7, and transported to a washing unit 11 as washing means. The washing unit 11 has a spinner table (holding means) 11a for holding the plate-like object W. The washing unit 11 includes washing water supply unit 12 and warm water supply unit 13 as warm medium supply means.

The plate-like object W transported to the washing unit 11 has the ground surface washed with washing water with the surface adhered with the thermoshrinkable tape T preferentially held under suction on the spinner table 11a. In the washing process, spin washing is performed while supplying the washing water from the washing water supply unit 12 to the ground surface.

After the washing process is completed, the plate-like object W is inverted by the transporting/inverting unit 3. In the inverting process, the plate-like object W is sucked from thereunder by the sucking member 3d of the transporting/inverting unit 3, i.e., the plate-like object W is lifted from the spinner table 11a with the surface thereof to which the thermoshrinkable tape T is adhered being sucked. The sucking member 3d is then inverted by 180°, while the sucking state is retained, and the plate-like object is held again under suction on the spinner table 11a as holding means with the ground surface of the plate-like object W facing downward.

Thereafter, a warm medium supply process is performed in which a warm water as the warm medium at a desired temperature, e.g., preferably around 60 °C, is supplied from the warm water supply unit 13 to the thermoshrinkable tape T adhered to the surface of the plate-like object W. The warm water strips the thermoshrinkable tape T and then a discarding process is accomplished in which the shrinked and twisted thermoshrinkable tape T' is discarded into a tape trash box 14 by a discarding unit as discarding means. In this case, the second transporting unit 10 can also serve as the discarding means. The surface of the plate-like object W from which the thermoshrinkable tape T is stripped is washed with the warm water supplied to the plate-like object W.

After the thermoshrinkable tape T' is discarded, the plate-like object W is subjected to spin-drying. Finally, the plate-like object W is sucked by the transporting/inverting means 3 to be removed from the spinner table 11a and contained in the cassette 2' located in opposing relation to the cassette 2.

Although the thermoshrinkable tape T is shrinked and twisted with a supply of a warm air instead of warm water as warm medium, warm water is preferred to smoothly accomplish stripping.

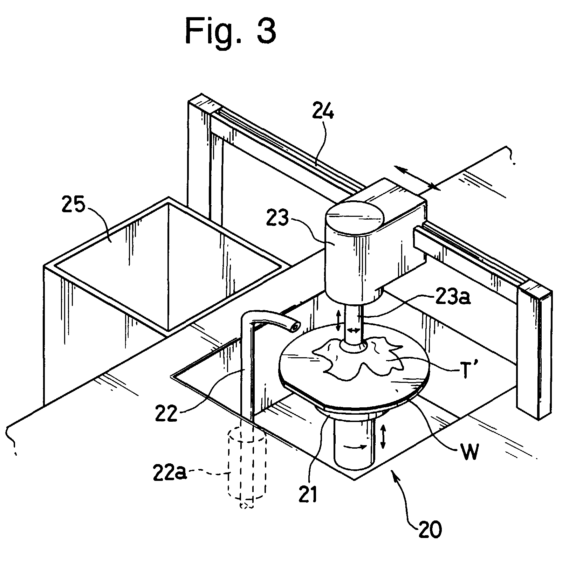

Fig. 3 shows another embodiment of the tape stripping apparatus according to the present invention, which comprises: spin table 21 as holding means for holding a plate-like object W; warm medium supply unit 22 for supplying warm medium to a thermoshrinkable tape adhered to the surface of the plate-like object W held by the spin table (holding means) 21; and discarding unit 23 as discarding means for discarding the thermoshrinkable tape T' that has been shrinked and twisted with the warm medium.

When the medium is water, the warm medium supply unit 22 also serves as washing water supply means. Specifically, the warm medium supply unit 22 has a heater 22a attached to the principal portion thereof and supplies warm water after heating washing water to an appropriate temperature (e.g., 60 °C) by means of the heater 22a or supplies the washing water without heating it. In washing the plate-like object W after the grinding process, therefore, it becomes possible to hold the plate-like object W under suction by using the spin table 21 with the thermoshrinkable tape T facing downward and wash the ground surface of the plate-like object W with the washing water being supplied, as described above.

The discarding unit 23 is formed movable along a guide rail 24 and has a sucking/discharging member 23a moving vertically and pivoting at the lower end thereof. The discarding unit 23 sucks the shrinked and twisted thermoshrinkable tape T' by using the sucking/discharging member 23a, lifts it from the plate-like object W, moves it along the guide rail 24 while holding it under suction, and releases it over the trash box 25 such that it falls into the trash box 25. The surface of the plate-like object W from which the thermoshrinkable tape T' is stripped is subjected to washing and drying processes, as described above.

Such a tape stripping apparatus 20 can be incorporated into the washing unit 11 of the grinding apparatus 1.

In supplying warm medium to the thermoshrinkable tape, warm medium is preferably supplied from the outer circumferential region of the plate-like object W to the inner portion thereof, while the plate-like object W is rotated.

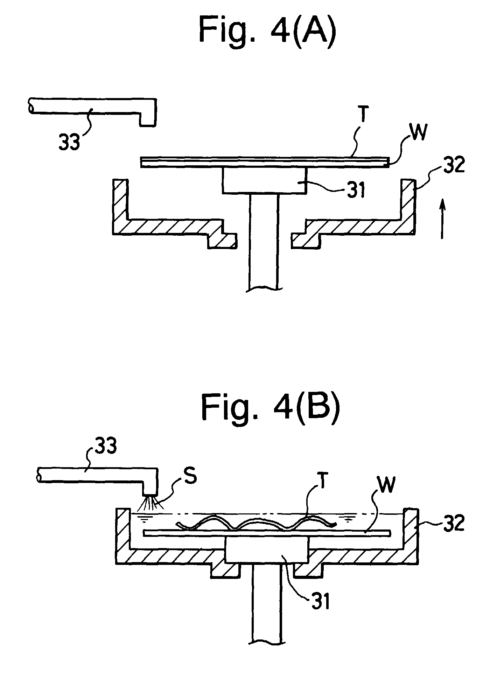

In a tape stripping apparatus according to another embodiment of the present invention, warm medium supply means may be submersible. For example, a generally cylindrical tub 32 which is vertically movable is disposed under spin table 31 (holding means), as shown in Figs. 4(A) and 4(B), the tub 32 is raised in level during the stripping of the thermoshrinkable protective tape T, and warm water S is supplied from a warm water supply pipe 33 to the tub 32 such that the protective tape T is submerged in the warm water S. In this case, the tub 32 and the warm water supply pipe 33 constitute the warm medium supply means according to the present invention. The protective tape T submerged in the warm water S is stripped from the plate-like object W in the shrinked and twisted state.

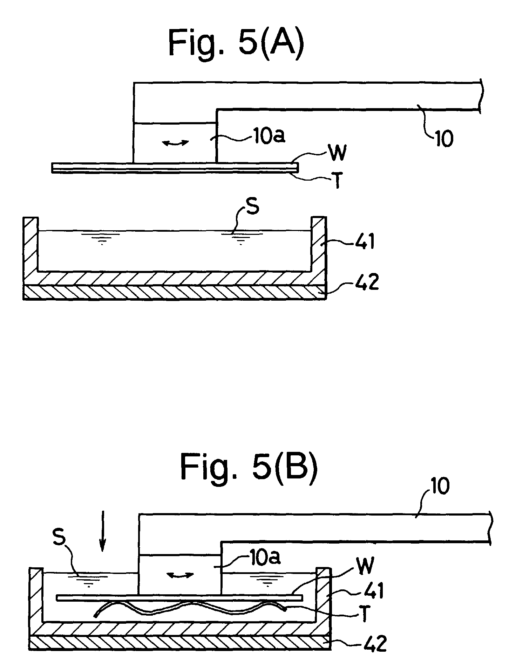

Alternatively, it is also possible to reserve warm water S at a specified temperature in a warm water tank 41, as shown in Figs. 5(A) and 5(B), hold the plate-like object W by using the holding unit 10a of the second transfer unit 10 shown in Fig. 1 with the thermoshrinkable protective tape T facing downward, submerge the plate-like object W in the warm water tank 41, and apply rotating movement with respect thereto via the holding unit 10a. The warm water tank 41 and a heater 42 provided on the bottom portion of the warm water tank 41 constitute the warm medium supply means. The protective tape T is stripped in a shrinked and twisted state from the plate-like object W and floats in the warm water tank 41. The warm water tank 41 with the heater may be provided at the current location of the trash box 14 in place of the trash box 14 or at a location adjacent the trash box 14 and within the reach of the holding unit 10a when it is rotated.

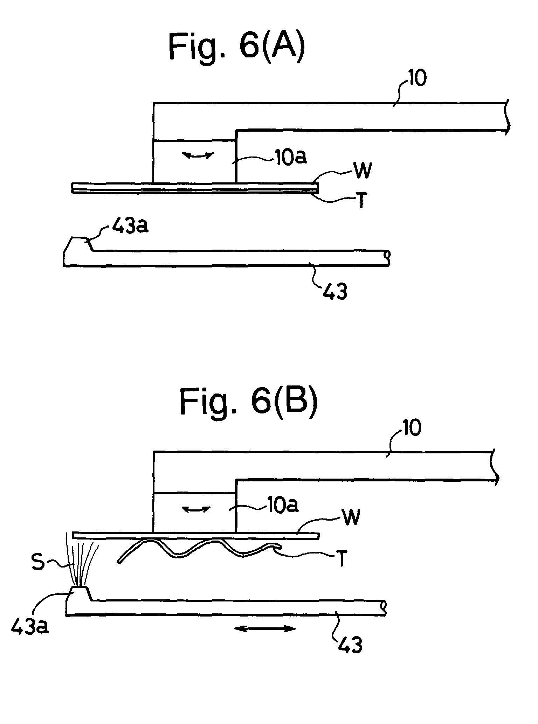

Instead of providing the warm water tank 41, it is also possible to spray warm water S to the thermoshrinkable protective tape T from a tip nozzle 43a of a warm water supply pipe 43, as shown in Figs. 6(A) and 6(B). In this case, the warm water supply pipe 43 may be caused to sway, as required, such that the warm water S is distributed evenly over the entire region of the protective tape T.

In either case, the warm medium supply means and the holding means are not limited to particular structures but may be structured appropriately without departing from the spirit of the present invention. If the stripped protective tape T floats in the warm water tank 41, e.g., the warm water tank 41 itself functions as the discarding means and may be structured appropriately without departing from the spirit of the present invention.

While the presently preferred embodiments of the present invention have been shown and described, it will be understood that the present invention is not limited thereto, and that various changes and modifications may be made by those skilled in the art without departing from the scope of the invention as set forth in the appended claims.

## Claims

1. A tape stripping apparatus for stripping a protective tape, for protecting a plate-like object, which is a thermoshrinkable tape, the apparatus comprising:
holding means for holding the plate-like object; and
warm medium supply means for supplying warm medium to the tape adhered to a surface of the plate-like object, the other surface of the plate-like object being held by the holding means.

2. A tape stripping apparatus according to claim 1, further comprising discarding means for discarding the protective tape being shrinked and twisted on the plate-like object with the warm medium supplied from the warm medium supply means.

3. A tape stripping apparatus according to claim 1 or 2, wherein said warm medium is one selected from the group consisting of warm water and warm air.

4. A tape stripping method according to claim 1 or 2, wherein the plate-like object is a semiconductor wafer.

5. A tape stripping method for stripping, from a plate-like object, a protective tape adhered to the plate-like object, the tape being a thermoshrinkable tape, the method being implemented by using a grinding apparatus including a tape stripping apparatus as recited in claim 2, the grinding apparatus comprising: a chuck table for holding the plate-like object under suction; grinding means for grinding the plate-like object held on the chuck table; transporting means for removing, from the chuck table, the plate-like object ground by the grinding means and transporting the plate-like object; and washing means, for holding and washing the plate-like object transported by the transporting means, comprising a spinner table, the method comprising:
a holding step of placing the plate-like object on the chuck table with the tape adhered to the plate-like object facing the chuck table and holding the plate-like object under suction;
a grinding step of grinding the plate-like object held on the chuck table by using the grinding means;
a transporting step of removing, after the grinding step is completed, the plate-like object from the chuck table and transporting the plate-like object to the spinner table of the washing means;
a washing step of holding the plate-like object under suction with the tape adhered to the plate-like object facing the spinner table and washing the plate-like object with the ground surface thereof facing outward, while supplying washing water to the plate-like object;
a plate-like object inverting step of inverting the plate-like object after the washing step is completed and placing again the plate-like object on the spinner table with the tape facing outward;
a warm medium supplying step of supplying, to the tape, warm medium at a desired temperature from the warm medium supply means; and
a discarding step of discarding the tape being shrinked and twisted on the plate-like object by using the discarding means.

6. A tape stripping method according to claim 5, wherein the warm medium is one selected from the group consisting of warm water and warm air.

7. A tape stripping method according to claim 5, wherein the plate-like object is a semiconductor wafer.
